# EUROPEAN PATENT SPECIFICATION

(11) **EP 1 439 745 B1**
(45) Date of publication and mention of the grant of the patent: **09.05.2007**
(21) Application number: 03016822.3
(22) Date of filing: 23.07.2003
(51) Int. Cl.: H05K 7/14

(54) **Backplane system and method for its use**
Rückwandverdrahtungssystem und Verwendungsverfahren
Système de fond de panier et procédé d'utilisation

(30) Priority: 14.01.2003 US 342966
(43) Date of publication of application: 21.07.2004
(73) Proprietor: Hewlett-Packard Development Company, L.P., Houston, TX 77070 (US)
(72) Inventor: Ballard, Curtis C., Eaton, CO 80615 (US)
(74) Representative: Schoppe, Fritz

(56) References cited:
- WO-A-93/22729
- US-A- 4 697 858
- US-A- 5 315 488
- US-A- 5 625 780
- US-A- 5 982 634
- US-B1- 6 349 037

## Description

### BACKGROUND

An electrical backplane contains sockets or slots for receiving and interconnecting other electronic components or assemblies. Backplanes have been widely used in the electrical arts to provide physical support, and shared resources, such as power, for interconnected electronic components or assemblies.

For example, electronic circuit cards can be physically inserted into the sockets or slots of a backplane for structural support. Additionally, the backplane provides a convenient platform for providing power to the circuit cards and for routing signals from one electronic circuit card to another.

In certain applications, multiple devices can be connected to the backplane and to the electronic circuit cards connected thereto. This configuration results in a system in which the backplane can become a shared medium for multiple devices.

One drawback of this configuration is that only a single device of the multiple devices in the system may transmit or receive data at any time through the backplane. As a result, the transfer or receipt of data transmitted or received as a large single file by one of the multiple devices produces inefficiencies within the overall system.
US-A-5,625,780 discloses a programmable backplane including a motherboard having slots for receiving printed circuit boards (PCBs). A field programmable interconnect device (FPID) mounted on the motherboard includes a programmable crosspoint switch for selectively routing signals between terminals of the PCBs. The routing is determined by input programming data. The FPID bi-directionally buffers all signals passing between ports of the crosspoint switch and the PCB terminals and can alter signal routing dynamically in response to routing instructions generated by instruction sources mounted on or connected to the PCBs. The programmable backplane may be used as a communication hub in a communication network or parallel processing system.
US-A-5,982,634 discloses a compact, high speed switch packaging arrangement providing reduced path lengths for electrical paths through the package. A printed circuit board switch backplane supports a switching subsystem and connects the switching subsystem to pairs of electrical connectors with the pairs of connectors being positioned on opposite edges of the same side of the backplane.
US 6,349,037 B1 discloses an electrical machine, such as a router, switch, hub, etc., including a housing in which a primary backplane and secondary backplane are mounted in stacked spaced relationship. A primary bus is fabricated on the primary backplane and a secondary bus is fabricated on the secondary backplane. Connectors with feed through elements provide mechanical support and electrical transmission between the primary backplane and Secondary backplane.
It is the object of the present invention to provide an improved backplane system and an improved method for routing data between components of an assembly which allow for an efficient transfer of data between a plurality of electrical components connected to the backplane.
This object is achieved by a backplane system according to claim 1, and by a method according to claim 8.

### SUMMARY

A backplane system includes a switch on a first backplane support. The switch concurrently routes a plurality of packetized data between a plurality of electrical components that are located within a single assembly.

In another embodiment, a backplane system includes a first backplane support having a first switch located on the first backplane support for concurrently routing packetized data between a plurality of electrical components located within a single assembly, where the plurality of components includes a robot control, a remote manager, a drive can, and a FC-SCSI interface; and a second backplane support communicatively coupled to the first backplane support, where the second backplane support includes a second switch located on the second backplane support for concurrently routing multiple units of packetized data between the first backplane support and the second backplane support.

In another embodiment, a method for routing information over a backplane system having a first backplane support includes concurrently receiving multiple data packets in a switch located on the first backplane support; interpreting the data packets; and routing the data packets to a plurality of electrical components located within a single assembly.

### BRIEF DESCRIPTION OF THE DRAWINGS

The accompanying drawings illustrate embodiments of the present invention and are a part of the specification. The illustrated embodiments are merely examples of the present invention and do not limit the scope of the invention. Throughout the drawings, identical reference numerals refer to similar, though not necessarily identical, elements.

**Figure 1** depicts at least one host bus adaptor interfaced with a system assembly according to an embodiment of the present invention.

**Figure 2a** depicts a base module for use in a system assembly according to an embodiment of the present invention.

**Figure 2b** depicts a stacking module for use in a system assembly according to an embodiment of the present invention.

**Figure 3** depicts a backplane for use in a system assembly according to an embodiment of the present invention.

**Figures 4a** and **4b** depict an embodiment of a drive can along with its block diagram according to an embodiment of the present invention.

**Figures 5a** and **5b** depict a FC-SCSI interface along with its block diagram according to an embodiment of the present invention.

**Figures 6a** and **6b** depict a robot control along with its block diagram according to an embodiment of the present invention.

**Figures 7a** and **7b** depict a remote module along with its block diagram according to an embodiment of the present invention.

**Figures 8a** and **8b** depict a slave controller along with its block diagram according to an embodiment of the present invention.

**Figures 9a** and **9b** depict a system assembly having a base module along with a stacking module according to an embodiment of the present invention.

### DETAILED DESCRIPTION

An apparatus and method will be described for using a hub or switch to concurrently route a plurality of packetized data between a plurality of electrical components within a single assembly that includes a common backplane. According to one examplary implementation, the backplane is used for concurrently communicating with multiple electrical components. As used herein, and in the appended claims, the term "switch" will be defined as meaning a switch, a hub or other data routing device.

### Examplary Overall Structure

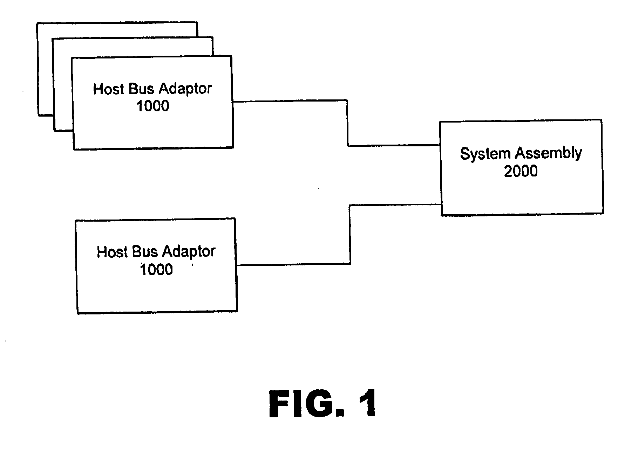

Figure 1 depicts a system that includes at least one host bus adaptor (HBA) (1000) electrically connected to a system assembly (2000). The host bus adaptor (1000) may be any device or system capable of transmitting packetized information, receiving packetized information, or both transmitting and receiving packetized information. As further explained herein, commands and data are transferable between the host bus adaptor (1000) and the system assembly (2000). Consequently, the host bus adaptor (1000) is used to interconnect other electronic components or assemblies with the system assembly (2000).

The host bus adaptor (1000) is external to the system assembly (2000), and may be co-located with the system assembly (2000) or remotely located from the system assembly (2000). When the host bus adaptor (1000) is co-located with the system assembly (2000), the host bus adaptor (1000) and the system assembly (2000) are present within the same room or facility such that the host bus adaptor (1000) and the system assembly (2000) are proximal to one another. When the host bus adaptor (1000) is remotely located from the system assembly (2000), the host bus adaptor (1000) and the system assembly (2000) are not present within the same room or facility. As further shown in Figure 1, the system assembly (2000) can concurrently support more than one host bus adaptor (1000).

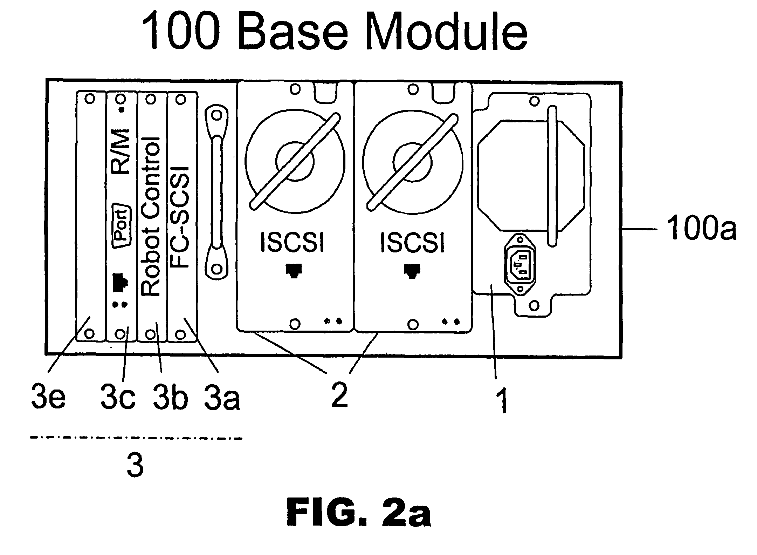

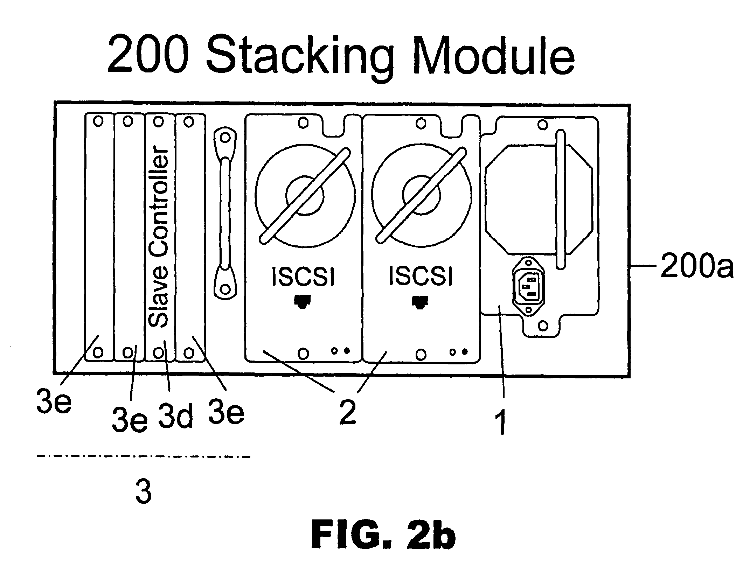

The details of the system assembly (2000) will now be described. The system assembly consists principally of two types of components, base modules (See Figure 2a) and stacking modules (See Figure 2b).

Figure 2a depicts a base module (100) for use in the system assembly (2000). The base module (100) is housed within an enclosure (100a) and includes, for example, a power supply (1), at least one drive can (2), and expansion cards (3).

The drive can (2) is an element in the system assembly containing a drive such as a tape, disk or other removable media drive, and the interface circuitry to connect to the other components within the system assembly. Two drive cans (2) are illustrated in Figure 1. However, it will be understood that any number of drive cans may be incorporated into a base module. The expansion cards (3) are assemblies of electronic components, typically on a circuit board or card, that provide additional functionality to the system assembly.

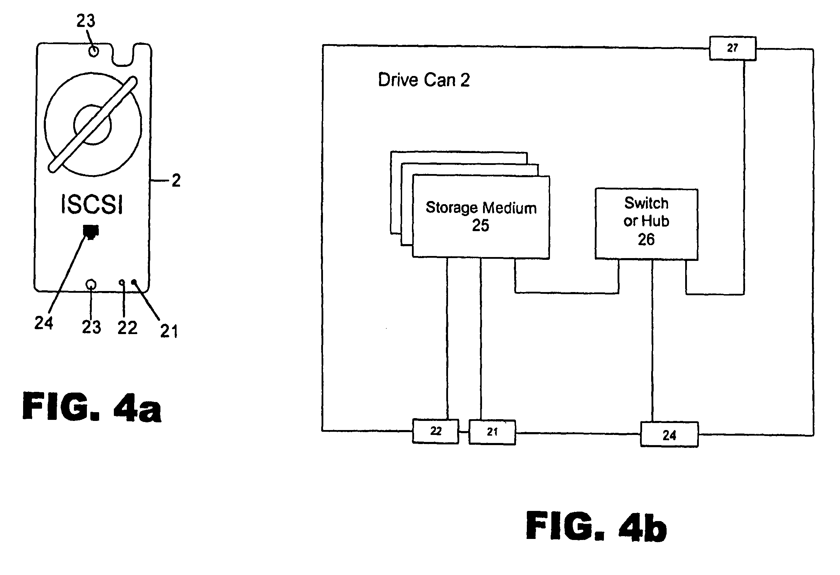

The enclosure (100a) provides the supporting frame of the base module (100) and houses the components (e.g., 1, 2 and 3) of the base module (100). The power supply (1) provides power to the drive can(s) (2) and the expansion cards (3) located within the base module (100). The drive can (2) is further described below with reference to Figures 4a and 4b.

Enclosure slots within the enclosure (100a) are structurally adapted to receive expansion cards (3). Expansion slot covers (3e) provide a covering for the unused enclosure slots.

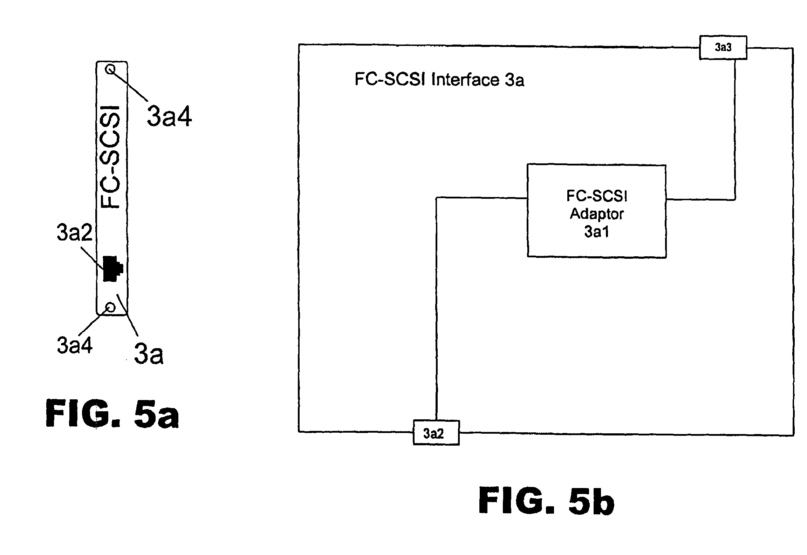

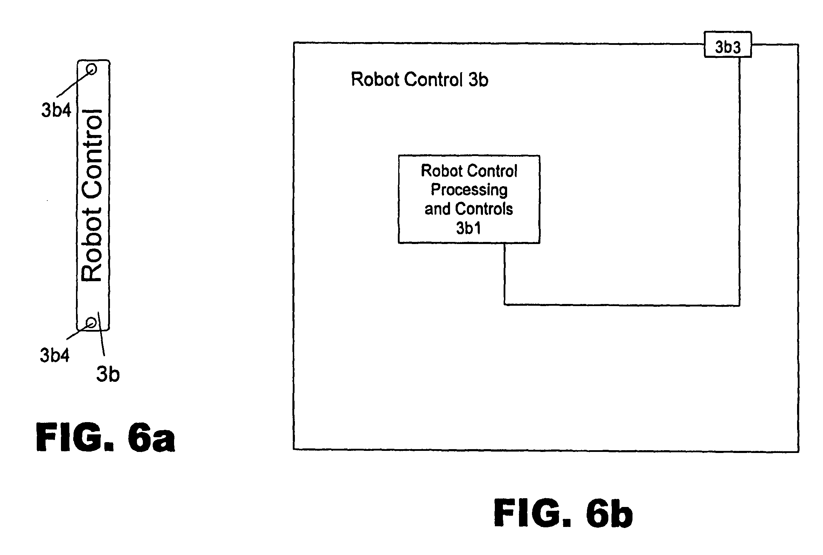

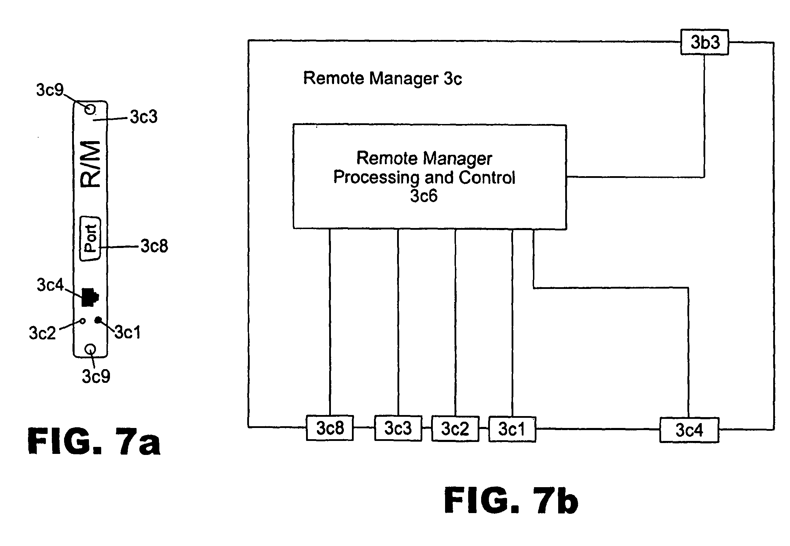

Expansion cards (3), usable with the base module (100), may include a Fibre Channel-Small Computer System Interface (FC-SCSI) (3a), a robot control (3b) and a remote manager (R/M) (3c). The FC-SCSI interface (3a) is further described below with reference to Figures 5a and 5b. Although one FC-SCSI interface (3a) is shown in Figure 1, a base module (100) may have more than one FC-SCSI interface (3a) or may exclude the FC-SCSI interface (3a). The robot control (3b) is further described below with reference to Figures 6a and 6b. The remote manager (R/M) (3c) is further described below with reference to Figures 7a and 7b.

Figure 2b depicts a stacking module (200). The stacking module (200) is housed within an enclosure (200a). Like the base module (100), the stacking module (200) also includes, for example, a power supply (1), a number of drive cans (2), and expansion cards (3). The enclosure (200a) provides the supporting frame of the stacking module (200) that houses the components (e.g., 1, 2 and 3).

The power supply (1) provides power to the drive can(s) (2) and the expansion cards (3) located within the stacking module (200). Although two drive cans (2) are shown within Figure 2, a stacking module (200) may include any number of drive cans (2) or may have no drive cans.

Enclosure slots within the enclosure (200a) are also structurally adapted to receive expansion cards (3). Expansion slot covers (3e) provide a covering for the unused enclosure slots.

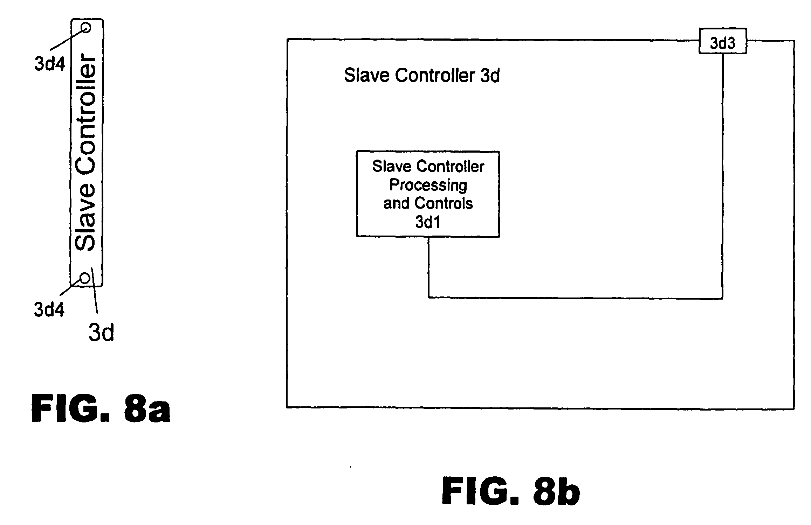

The expansion cards (3) of the stacking module (200) may include a slave controller (3d). An FC-SCSI interface (3a) is not shown in Figure 2b. However, a stacking module (200) may include one or more FC-SCSI interfaces. The slave controller (3d) is described further below with reference to Figures 8a and 8b.

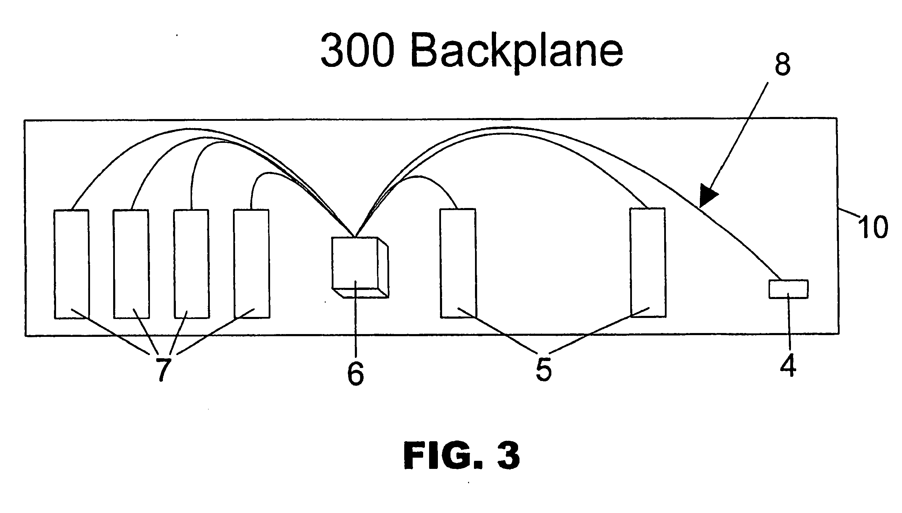

Figure 3 shows a backplane (300). The backplane (300) includes an inter-module connector (4), drive can connectors (5), a hub or switch interconnection (6), expansion card connectors (7), signal lines (8), and a backplane support (10). The backplane support (10) is a structure that retains the inter-module connector (4), the drive can connectors (5), the hub or switch interconnection (6), expansion card connectors (7), and signal lines (8) by securing the signal lines (8), connectors (4), (5) and (7), and the hub or switch interconnection (6) on a common platform. The power supply (1) of the base module of Figure 2a provides power to the hub or switch interconnection (6).

Figure 3 depicts the backplane (300) as having a star configuration. Specifically, the signal lines (8) connect the hub or switch interconnection (6) to the connectors (4), (5), and (7). Connectors (4), (5), and (7) are connected to each other through the hub or switch interconnection (6).

Although the backplane (300) shown in Figure 3 is a star configuration, implementing the backplane (300) of Figure 3 as a ring configuration is also possible. When implementing the backplane with a ring configuration, instead of a star configuration, the signal lines (8) connect the connectors (4), (5), and (7) and the hub or switch interconnection (6) in series to form a closed loop. Each signal line (8) is a coaxial cable, a twisted pair cable, a fibre optic cable, or any communication line suitable for use with Ethernet technology or the like.

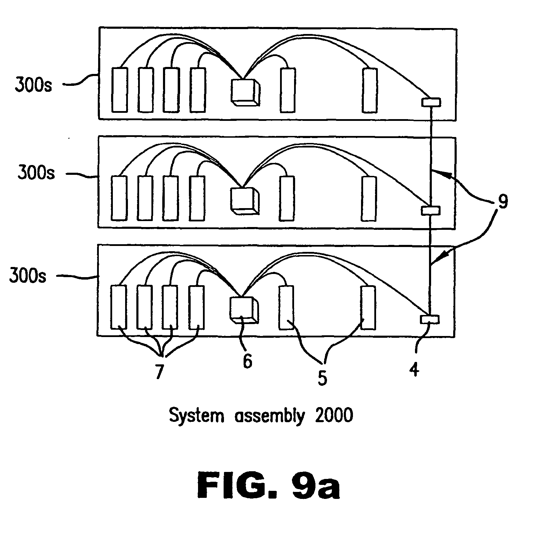

The backplane (300) is preferably incorporated within the enclosure (100a) of the base module (100) as a base module backplane (300b, Figure 9a). A another backplane (300) is incorporated within the enclosure (200a) of the stacking module (200) as a stacking module backplane (300s, Figure 9a).

Referring again to Figure 3, each drive can connector (5) is structurally adapted to receive and retain a drive can (2), and to transfer signals between the backplane (300) and a corresponding drive can (2). Each expansion card connector (7) is structurally adapted to receive and retain an expansion card (3), and is also suitable for transferring signals between a corresponding expansion card (3) and the backplane (300). Signals are transferred throughout the backplane (300) over the signal lines (8). The signal lines (8) are connected to the inter-module connector (4), the drive can connectors (5), the hub or switch interconnection (6), and expansion card connectors (7). Each of the signal lines (8) is an interconnection suitable for transferring signals such as an analog signal and/or a digital signal.

Consequently, a backplane (300) such as that illustrated in Figure 3 provides the backbone for the base module (100, Figure 2a) and for the stacking module (200, Figure 2b). The backbone is the internal communication bus that interconnects the various components (e.g., 1, 2 and 3) housed within the enclosure (100a or 200a) and provides internal communication within the system assembly.

### Exemplary Implementation and Operation

This exemplary embodiment uses an Ethemet-based network to establish a communication bus internal to a system assembly. Ethernet is a serial interface used for the rapid and efficient transfer of signals. Previously, Ethernet technology has been implemented to connect various assemblies to one another as local area networks (LAN) and wide area networks (WAN). The various assemblies are usually located at different locations and are generally separated by great distances. However, Ethernet technology can be used in the embodiments described herein as an internal communication bus between the base and stacking module components (e.g., 2 and 3, Figures 2a and 2b) housed within the module enclosures (100a or 200a, Figures 2a and 2b).

Small computer system interface (SCSI) is an American National Standards Institute (ANSI) standard for interconnecting computers and peripheral devices. This standard defines the electrical characteristics, cable and connector requirements, signals, bus timing and commands used to implement a parallel bus for interconnecting computers and peripheral devices. The Internet SCSI (iSCSI) is another SCSI networking standard used to manage information transmission over networks. This information is typically in the form of commands and data. Unlike SCSI, iSCSI is suitable for use with serial bus networks such as the Internet and the Ethernet.

In the embodiments described herein, any packetized network protocol compatible with the Ethernet technology, such as iSCSI protocol, can be used to transmit data over the backbone of the backplane (300) as packetized backplane data. Specifically, referring again to Figure 1, information is transferable between the host bus adaptor (1000) and the system assembly (2000) as a file.

Instead of transferring an entire file as a continuous stream, the file is preferably sent from its source to its destination in packets of data. The source is a system or assembly that originates the data file and the destination is the system or assembly that receives the file. The packet, also known as a datagram, is a unit of information that is typically smaller that the entire file being transferred.

Prior to transmission of the file, the source divides the file into a series of smaller portions for efficient routing over the network. Each of these smaller portions forms a packet. These packets may include a header having the address of the source, the address of the destination, control information, and a packet identifier. These packets may also include user data along with commands. The source and the destination are separately identified by addresses. One address uniquely identifies the source, while another address uniquely identifies the destination. The packet identifier is a number or code that uniquely identifies a specific data packet and its place in the file being transmitted. The header and user information are added to the packet before the packet is transmitted over the network.

Once the header and user information are added, the packet is then dispatched from the source onto the network for transmission to the destination. The individual packets may travel along the same or different routes throughout the network.

Referring again to Figure 3, the hub or switch interconnection (6) is suitable for transferring data packets between the inter-module connector (4), the drive can connectors (5) and the expansion card connectors (7). Data packets are routed individually within the backplane (300) as packetized information when the host bus adaptor (1000; Figure 1) is the source and the system assembly (2000; Figure 1) is the destination or when the system assembly (2000) is the source and the host bus adaptor (1000) is the destination or when a component in the system assembly (2000) is the source and another component in the system assembly (2000) is the destination.

The hub or switch interconnection (6) of Figure 3 can be, for example, an Ethernet hub or an Ethernet switch or other suitable device. When the host bus adaptor (1000) is the source and the system assembly (2000) is the destination, and the interconnection (6) is used as an Ethernet hub, the hub (6) receives a data packet from the host bus adaptor (1000) and indiscriminately retransmits the data packet to the components (e.g., 2 and 3) connected to the backplane (300) as a backplane data packet. Specifically, the hub (6) retransmits the packet through the drive can connector (5) to the drive can (2), through the expansion card connector (7) to the expansion cards (3), and through the inter-module connector (4) to another backplane (300), if one is connected. All components (e.g., 2 and 3) on the backplane (300) may receive the packets. Additionally, another backplane (300) may also receive the packets through the inter-module connector (4).

Furthermore, when the host bus adaptor (1000) is the source and the system assembly (2000) is the destination and when the hub or switch interconnection (6) is used as an Ethernet switch, the switch (6) receives a packet from the host bus adaptor (1000) and retransmits the packet as packetized information only to a specific component (e.g., 2 or 3) connected to the backbone (300). In particular, circuitry contained within the switch (6) extracts the address from the data packet and determines the intended recipient component for that packet. Once determined, the switch (6) retransmits the backplane packet only to the addressed component and no other component receives the packet.

When the system assembly (2000) is the source and the host bus adaptor (1000) is the destination, the component of the system assembly (e.g., a drive can (2) or an expansion card (3)) divides the files into packets and adds the header and user data. The hub or switch interconnection (6) receives a packet from the component (e.g., 2 or 3) or from the inter-module connector (4) and transmits the packet to the host bus adaptor (1000).

Furthermore when a component in the system assembly (2000) is the source and another component in the system assembly (2000) is the destination and the hub or switch interconnection is a switch, the packet is retransmitted only internally to the system assembly (2000) and is not copied to the host bus adaptor (1000). Furthermore when the host bus adaptor (1000) is addressing a device outside the system assembly (2000) and the hub or switch interconnection is a switch, the packets are not retransmitted internally to the system assembly (2000).

### Drive Can

Figures 4a and 4b depict a typical drive can (2) as used within the base module (100) and the stacking module (200). The drive can (2) is an element in the system assembly (2000, Figure. 1) containing a drive such as a tape, disk or other removable media drive, and the interface circuitry to connect to the other components within the system assembly. More specifically, a drive can (2) is to be understood as an Internet small computer system interface (iSCSI) storage library capable of receiving packeted data and commands over a network connection. A drive can preferably includes a drive or storage unit, a switch or hub, and a network connector.

Figure 2a depicts two drive cans (2) housed within the base module (100), and Figure 2b depicts two drive cans (2) housed within the stacking module (200). However, it will be understood that any number of drive cans may be used in either module depending upon the needs of a particular application. While a drive can (2) is depicted within the Figures and described herein, any component that has the capability for receiving packeted data and packeted commands could be used in place of, or in addition to, a drive can.

As shown in Figure 4a, the drive can (2) is preferably an iSCSI device that typically includes indicators (21) and (22), mounting fasteners (23), and a connector (24). Indicator (21) is a power indicator that shows whether the drive can (2) is receiving power from the power supply (1). Indicator (22) is a status indicator that shows whether the drive can (2) is functioning normally. The mounting fasteners (23) of Figure 4a preferably include screws, locking mechanisms, or any other hardware that is structurally adapted to secure the drive can (2) to the enclosure (100a or 200a) of the stacking or base module.

The connector (24) is any connector that is suitable for receiving electrical signals from the host bus adaptor (1000), including but not limited to, an RJ-45 connector. Thus, the host bus adaptor (1000) can be connectable to any drive can (2) located within the system assembly (2000). Even when the host bus adaptor (1000) is connected to a particular drive can (2), the host bus adaptor (1000) may access another component located within the system assembly (2000). Specifically, packetized information is transferable between the host bus adaptor (1000) and any other component (e.g., 2 or 3) housed within the system assembly (2000) when the host bus adaptor (1000) is connected to a drive can (2).

Figure 4b further shows a storage medium (25), a switch or hub (26), and a drive can connector (27). The drive can connector (27) mates with a drive can connector (5, Figure 3) of the backplane (300). The drive can (2) is connected through the drive can connector (27) and the drive can connector (5) of the backplane (300) to the hub or switch interconnection (6) of the backplane (300). The drive can (2) typically contains at least one storage medium (25) communicatively coupled to the switch or hub (26). The storage medium (25) includes but is not limited to an optical storage medium, a magnetic storage medium or both. The optical storage medium includes but is not limited to a compact disc (CD), a digital versatile disk (DVD), a laser disc (LD) or a magneto-optical (MO) disc or the like. The magnetic storage medium may include, but is not limited to, a magnetic tape or a magnetic disc.

The switch or hub (26) controls communications between the storage medium (25), any external device (such as a host bus adaptor) connected to the can (2) through the connector (24) and the hub or switch interconnection (6) connected to the connector (27). Specifically, when the hub or switch (26) is used as an Ethernet hub (6), the hub (26) can receive a backplane data packet from the hub or switch interconnection (6) located on the backplane (300), via connector (24). When a host bus adaptor (1000) is connected to the connector (24), the hub (26) also communicates with the host bus adaptor (1000) by receiving and transmitting packetized information through the connector (24). The hub (26) may receive packetized information from the hub or switch interconnection (6) of the backplane (300) while concurrently receiving packetized information through the connector (24) or while concurrently transferring packetized information through the connector (24) to a host bus adaptor (1000). The hub (26) may also transmit packetized information to the hub or switch interconnection (6) of the backplane (300) while concurrently receiving packetized information from a host bus adaptor (1000) through the connector (24) or while concurrently transferring packetized information through the connector (24) to a host bus adaptor (1000). In addition, the hub (26) may receive packetized information through the connector (24) from a host bus adaptor (1000) while concurrently receiving packetized information from the hub or switch interconnection (6) of the backplane (300) or while concurrently transferring packetized information to the hub or switch interconnection (6) of the backplane (300). Furthermore, the hub (26) may transfer packetized information through the connector (24) to a host bus adaptor (1000) while concurrently receiving packetized information from the hub or switch interconnection (6) of the backplane (300) or while concurrently transferring packetized information to the hub or switch interconnection (6) of the backplane (300). Additionally, a host bus adaptor (1000) can be connected to the hub (26) through the hub or switch interconnection (6) or only through the connector (24). Once received, the hub (26) indiscriminately retransmits the received data packet to all other components in the system assembly (2000) and to the storage media (25) contained within the drive can (2).

Alternatively, the hub or switch (26) may be implemented as an Ethernet switch. The switch (26) receives a backplane data packet from the hub or switch interconnection (6) located on the backplane (300). When a host bus adaptor (1000) is connected to the connector (24), the switch (26) also communicates with the host bus adaptor (1000) by receiving and transmitting packetized information through the connector (24). The switch (26) may transmit packetized information to the hub or switch interconnection (6) of the backplane (300) while concurrently receiving packetized information from a host bus adaptor (1000) through the connector (24) or while concurrently transferring packetized information through the connector (24) to a host bus adaptor (1000). In addition, the switch (26) may receive packetized information through the connector (24) from a host bus adaptor (1000) while concurrently receiving packetized information from the hub or switch interconnection (6) of the backplane (300) or while concurrently transferring packetized information to the hub or switch interconnection (6) of the backplane (300). Furthermore, the switch (26) may transfer packetized information through the connector (24) to a host bus adaptor (1000) while concurrently receiving packetized information from the hub or switch interconnection (6) of the backplane (300) or while concurrently transferring packetized information to the hub or switch interconnection (6) of the backplane (300). Moreover, a host bus adaptor (1000) can be connected to the switch (26) through the hub or switch interconnection (6) or through the connector (24).

The switch (26) retransmits the backplane data packet received from the hub or switch interconnection (6) located on the backplane (300) and the packetized information received from the connector (24). The backplane data packet from the backplane (300) and the packetized information from the connector (24) are retransmitted by the switch (26) to only the addressed destination, which may be a specific storage medium (25) contained within the drive can (2) or another component in the system assembly (2000). In particular, circuitry contained within the switch (26) extracts the address from the data packet and determines the intended destination for that data packet. Once determined, the switch (26) retransmits the data packet only to the addressed destination and no other component receives the retransmitted data packet.

Once communication has been established, packetized information can be transferred between a host bus adaptor (1000) and the selected storage medium (25). Upon receipt of the data packet, circuitry contained within each storage medium (25) extracts the address from the data packet to determine if the data packet is intended for that specific storage medium (25). Typically, the storage medium (25) will refrain from further processing the data packet unless that data packet contains the address for the storage medium (25). The data packet is ignored by all but the recipient storage medium (25). When, however, the circuitry contained within the storage medium (25) elects to ignore this addressing scheme, the storage medium (25) will process the data packet, even if that data packet does not contain the address for that storage medium (25). Once all of the data packets have arrived at the destination, the original data file is reassembled from the data packets using the packet identifiers contained within the data packets.

### Fibre Channel

Figures 5a and 5b depict the fibre channel to the SCSI (FC-SCSI) interface (3a). Figure 2a depicts the FC-SCSI interface (3a) housed within the base module (100). However, the FC-SCSI interface (3a) is an optional electrical component for the base module (100). Thus, a base module (100) without an FC-SCSI interface (3a) may also be used. As shown in Figure 5a, the FC-SCSI interface (3a) includes the FC-SCSI interface connector (3a2) and the mounting fasteners (3a4) such as screws, locking mechanisms, or any other hardware that is structurally adapted to secure the FC-SCSI interface (3a) to the enclosure (100a). The FC-SCSI interface connector (3a2) is defined by a standards committee and may be any approved FC-SCSI connector.

Figure 5b further shows a FC-SCSI adaptor (3a1) and the FC-SCSI connector (3a3). The FC-SCSI connector (3a3) mates with an expansion card connector of a backplane (300). The FC-SCSI interface (3a) is connected through the expansion card connector (7) to the hub or switch interconnection (6) of the base module backplane (300b, Figure 9a). While an FC-SCSI interface (3a) is depicted within the Figures, any component may be used that is structurally and electrically adapted for connection to the expansion card connector (7) of the base module backplane (300b) and has the capability for receiving packeted information.

Fibre channel is a serial data transmission interface used for connecting various devices. The FC-SCSI interface (3a) is an electrical component that is contained on an expansion card (3). The FC-SCSI interface (3a) enables a host bus adaptor (1000) to interface with the system assembly (2000) when the host bus adaptor (1000) uses fibre channel technology to transfer data. Specifically, data packets sent from a host bus adaptor (1000) are received at the FC-SCSI interface connector (3a2) and are transferred to the FC-SCSI adaptor (3a1). The FC-SCSI adaptor (3a1) converts the fibre channel-formatted data packets received from the host bus adaptor (1000) into data that can be routed over the backplane of the base module (100) as packetized backplane data. The converted data packets are transferred from the FC-SCSI adaptor (3a1), through the FC-SCSI connector (3a3) and the expansion card connector (7), onto the backplane (300) for further processing by the hub or switch interconnection (6).

In addition, backplane data packets sent from the backplane (300b) of the base module (100) to the FC-SCSI interface (3a) for subsequent transfer to the host bus adaptor (1000) are routed by the hub or switch interconnection (6) to the expansion card connector (7), and through the FC-SCSI connector (3a3), for conversion by the FC-SCSI adaptor (3a1) into fibre channel-formatted data. Once converted, the fibre channel-formatted data is transferred through the FC-SCSI interface connector (3a2) to the host bus adaptor (1000). The hub or switch interconnection (6) located on the base module backplane (300b) may concurrently route the packetized information between the FC-SCSI interface (3a) and the drive can (2). Additionally, the hub or switch interconnection (6) may concurrently route the packetized information between the FC-SCSI interface (3a) and another component (e.g., 3) of the system assembly (2000). Furthermore, the hub or switch interconnection (6) may concurrently route the packetized information between the FC-SCSI interface (3a) and the inter-module connector (4) of the system assembly (2000).

### Robot Control

Figures 6a and 6b depict the robot control (3b) in further detail. Figure 2a shows the robot control (3b) housed within the base module (100). The robot control (3b) is an electrical component of the system assembly (2000; Figure 1) that controls a robot that moves removable media between drive cans and storage slots so that more media can be stored than can be mounted in the drive cans. As further shown in Figure 6a, the robot control (3b) includes mounting fasteners (3b4). The mounting fasteners (3b4) include screws, locking mechanisms, or any other hardware that is structurally adapted to secure the robot control (3b) to the enclosure (100a, Figure 2a).

Figure 6b further shows the robot control processing and controls (3b1) and the robot control connector (3b3) which mates with an expansion card connector (7) of the backplane (300, Figure 3). The robot control processing and controls (3b1) communicate with the storage medium (25) of a drive can (2) through the robot control connector (3b3). In particular, when a host bus adaptor (1000) sends a command to the system assembly (2000, Figure 1) for the storage or retrieval of information, that command from the host bus adaptor (1000) is received by the system assembly (2000), transferred from the hub or switch interconnection (6) of the backplane (300b, Figure 9a), through the robot control connector (3b3), to the robot control (3b) for further processing by the robot control processing and controls (3b1).

The robot control processing and controls (3b1) maintains a database that identifies all storage media (25) located within the system assembly (2000). Using this database, the robot control processing and controls (3b1) can uniquely identify a specific storage medium (25) that is located within a particular drive can (2) or in a storage slot, and can also generate control commands to control the specific storage medium (25) or load the specific storage medium in a drive can. In particular, the switch or hub (26) of the drive can (2) receives and retransmits instruction from the robot control (3b) to control the selection of the storage medium (25) located within the associated drive can (2), to control both the storage of data onto the storage medium (25) and retrieval of data from the storage medium (25).

Upon receipt of the command from the host bus adaptor (1000), the robot control processing and controls (3b1) generate a control command. This instruction is generated as a data packet or series of data packets that is routed over the backplane (300b) of the base module (100) and identifies and controls the specific storage medium (25) for data storage or retrieval based upon the command from the host bus adaptor (1000).

Once generated, the control command is sent through the robot control connector (3b3) and the expansion card connector (7) as packeted data for further handling by the hub or switch interconnection (6) of the backplane (300b), as described above. This handling by the hub or switch interconnection (6) includes the transfer of the control command to the particular drive can (2). Processing of the control command by the particular drive can (2) results in the selection of the specific storage medium (25) for the subsequent storage or retrieval as requested by the command from the host bus adaptor (1000).

The hub or switch interconnection (6) located on the backplane (300) may route the packetized data throughout the system assembly (2000) concurrently with routing the packetized control command between the robot control (3b) and a drive can (2) of the system assembly (2000). Additionally, the hub or switch interconnection (6) located on the backplane (300) may route the packetized information throughout the system assembly (2000) concurrently with routing the packetized control command between the robot control (3b) and another component (3) of the system assembly (2000). Furthermore, the hub or switch interconnection (6) located on the backplane (300) may route the packetized data throughout the system assembly (2000) concurrently with routing the packetized control command between the robot control (3b) and the inter-module connector (4).

### Remote Manager

Figures 7a and 7b depict the remote manager (R/M) (3c) in further detail. Figure 2a depicts the remote manager (3c) housed within the base module (100). The remote manager (3c) is an electrical component of the system assembly (2000) that provides an interface to receive instructions and data from a computer or other processing device. The remote manager (3c) processes these instructions and data to configure the system assembly (2000; Figure 1). While a remote manager (3c) is depicted within the Figures, any electrical component that is structurally and electrically adapted for connection to the expansion card connector (7) of the module backplane (300) and has the capability for receiving packeted information may be used.

As shown in Figure 7a, the remote manager (R/M) (3c) includes indicators (3c1), (3c2) and (3c3), the connector (3c4), the port (3c8) and mounting fasteners (3c9) including screws, locking mechanisms, or any other hardware that is structurally adapted to secure the remote manager (R/M) (3c) to the enclosure (100a; Figure 2a). Figure 7b further shows the remote manager processing and control (3c6), and the R/M connector (3c7) which mates with an expansion card connector (7). Indicators (3c1), (3c2) and (3c3) are indicators that preferably include an activity indicator, a link indicator, power indicator and collision indicator. Indicators (3c1) and (3c2) may be light emitting diode (LED) indicator. Indicator (3c3) is a power indicator that shows whether the remote manager (3c) is receiving power from the power supply (1).

The connector (3c4) is any connector that is suitable for receiving electrical signals from a host bus adaptor (1000), including but not limited to, an RJ-45 connector. Thus, the host bus adaptor (1000) can be connected to the remote manager (3c) within the system assembly (2000). Even when the host bus adaptor (1000) is connected to the remote manager (3c), the host bus adaptor (1000) may access another component (e.g., 2 or 3) located within the system assembly (2000). Specifically, packetized information is transferable between the host bus adaptor (1000) and any other component (2), (3) housed within the system assembly (2000), via hub or switch interconnection (6) when the host bus adaptor (1000) is connected to the remote manager (3c).

The port (3c8) provides a connection to a computer or other processing device. Through the port (3c8), the remote manager (3c) receives instructions and data from the computer or other processing device. The remote manager processing and control (3c6) processes the instructions and data to initialize or reconfigure the remote manager. Once instructions and data received by the remote manager (3c) are processed to produce configuration information, the configuration information is transferred as configuration information data packets through the R/M connector (3c7) and the expansion card connector (7), and onto the module backplane (300b, Figure 9a), for further handling by the hub or switch interconnection (6).

The hub or switch interconnection (6) located on the base module backplane (300) may concurrently route the packetized information between the remote manager (3c) and the drive can (2). The hub or switch interconnection (6) may also concurrently route the packetized information between the remote manager (3c) and another component. Furthermore, the hub or switch interconnection (6) may concurrently route the packetized information between the remote manager (3c) and the inter-module connector (4).

### Slave Controller

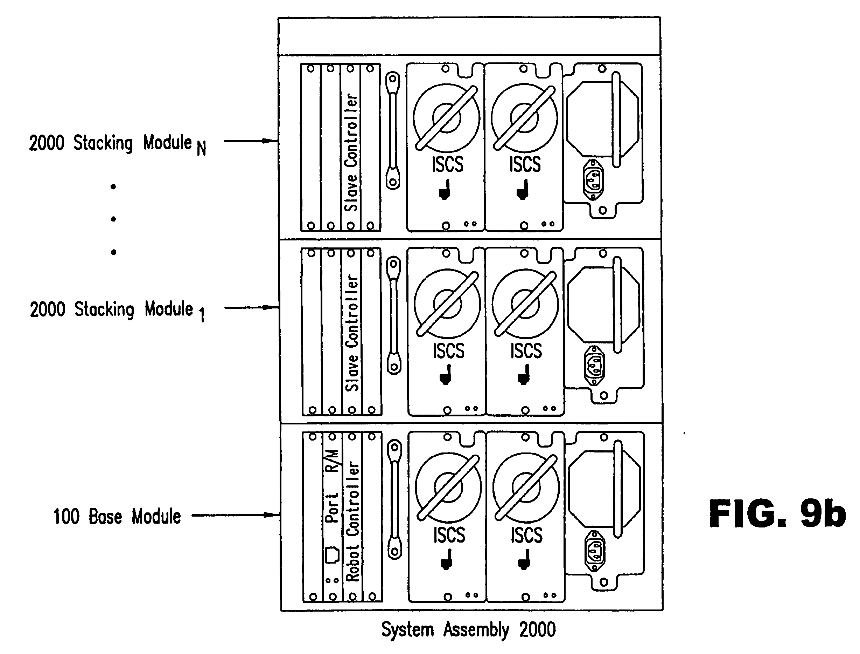

Figures 8a and 8b depict the slave controller (3d) in greater detail. Figure 2b shows the slave controller (3d) housed within a stacking module (200). The slave controller (3d) is an electrical component, preferably an expansion card (3). The slave controller connector (3d3) mates with an expansion card connector (7) located on a stacking module backplane (300s, Figure 9a). When the system assembly (2000) includes the stacking module (200), as shown in Figures 9a and 9b, the slave controller (3d) works in conjunction with the hub or switch interconnection (6) of the stacking module backplane (300s) and in conjunction with the robot control (3b) to connect an appropriate storage medium (25) housed within the stacking module (200) to a host bus adaptor (1000).

As shown in Figure 8a, the slave controller (3d) includes mounting fasteners (3d4) such as screws, locking mechanisms, or any other hardware that is structurally adapted to secure the slave controller (3d) to the enclosure (200a). Figure 8b further shows the slave controller processing and controls (3d1) and the slave controller connector (3d3).

The slave controller (3d) communicates with the robot control (3b) to connect an appropriate storage medium (25) housed within the stacking module (200) to a host bus adaptor (1000, Figure 1). In particular, when the host bus adaptor (1000) sends a command to the system assembly (2000) for the storage or retrieval of information, that command from the host bus adaptor (1000) is received by the system assembly (2000) and processed by the robot control (3b) housed within the base module (100). The robot control (3b) can uniquely identify a specific storage medium (25) that is located within a particular drive can (2) housed within the stacking module (200) and can also generate a control command to control the specific storage medium (25).

This control command is generated as a data packet or series of data packets. Once generated, this command is sent from the robot control (3b), through the inter-module connector (4) located on a base module backplane (300b, Figure 9a), through the inter-module connector (4) located on the stacking module backplane (300s, Figure 9a), through the hub or switch interconnection (6) located on the stacking module backplane (300s), to the slave controller (3d).

Upon receipt of the command from the robot control (3b), the slave controller processing and controls (3d1) generate an instruction to control the specific storage medium (25) housed within the stacking module (200). This instruction is generated as a data packet or series of data packets that is routed over the backplane (300s) of the stacking module (200). Once generated, the instruction is sent through the slave controller connector (3d3) as packeted data for further handling by the hub or switch interconnection (6) located on the stacking module backplane (300s), as described above. The switch or hub (26) of the drive can (2) housed within the stacking module (200) receives and retransmits an instruction from the slave controller (3d) to control the selection of the storage medium (25) located within the associated drive can (2), to control the storage of data onto the storage medium (25), and to control retrieval of data from the storage medium (25).

The hub or switch interconnection (6) may be located on the backplane (300s) and may be routing the packetized data throughout the system assembly (2000) concurrently with routing the packetized control command between the slave controller (3d) and a drive can (2) of the system assembly (2000). The hub or switch interconnection (6) may be located on the backplane (300s) and may be routing the packetized data throughout the system assembly (2000) concurrently with routing the packetized control command between the slave controller (3d) and another component (3) of the system assembly (2000). Furthermore, the hub or switch interconnection (6) may be located on the backplane (300s) and may be routing the packetized data throughout the system assembly (2000) concurrently with routing the packetized control command between the slave controller (3d) and the inter-module connector (4).

### System Assembly

Figures 9a and 9b depict the system assembly (2000) that includes the base module (100) along with at least one stacking module (200). As shown in Figures 9a and 9b, the system assembly (2000) is expandable to include a base module (100) along with two or more stacking modules (200). The stacking modules each include a stacking backplane (300s), as shown in Figure 9b. The base module backplane (300b) and the stacking module backplane (300s) shown in Figure 9a are preferably structured according to the backplane (300) of Figure 3.

When at least one stacking module (200) is used within the system assembly (2000), the inter-module connector (4) is suitable for transferring signals between the base module backplane (300b) and the stacking module backplane (300s). The base module backplane (300b) interfaces to the stacking module backplane (300s) through the inter-module connector (4) and signal line (9).

In the configuration shown in Figures 9a and 9b, signals are transferred between the base module (100) and one or more stacking modules (200) through the inter-module connectors (4) and over the signal lines (9). Each of the signal lines (9) is an interconnection suitable for transferring signals such as an analog signal and/or a digital signal.

## Claims

1. A backplane system for routing data between a plurality of electrical components (1, 2, 3, 3a-3e) located within a single assembly (100a, 100b), the backplane system comprising:
a first backplane support (10);
a first switch (6) arranged on said first backplane support (10) and adapted for concurrently routing packetized data;
a plurality of electrical component connectors (4, 5, 7) arranged on said backplane support (10), and each being structurally adapted to receive and retain an electrical component (1, 2, 3, 3a-3e); and
a plurality of signal lines (8) for routing packetized data between said first switch (6) and at least one electrical component connector (4, 5, 7).

2. A backplane system according to claim 1, wherein said plurality of electrical component connector connectors (4, 5, 7) comprises:
a first electrical component connector (5) being structurally adapted to receive and retain a first electrical component (2) for transferring said packetized data between said assembly (100a, 200a) and an external apparatus (1000, 2000); and
a second electrical component connector (7) being structurally adapted to receive and retain a second electrical component (3b) for generating and transferring packetized data in the form of a command.

3. A backplane system according to claim 2, wherein said packetized data in the form of a command is concurrently routed with said packetized data by said first switch (6), said packetized data in the form of a command comprising a packetized command used to control said first electrical component.

4. A backplane system according to one of claims 1 to 3, wherein said first switch comprises a hub (6), said hub (6) being adapted to receive said packetized data and to indiscriminately retransmit said packetized data to said plurality of electrical components (1, 2, 3, 3a-3e) located within said single assembly (100a, 200a).

5. A backplane system according to one of claims 1 to 3, wherein said first switch comprises a switch (6) configured to retransmit packetized data to a target electrical component of said plurality of electrical components (1, 2, 3, 3a-3e) based, at least in part, on information within said packetized data.

6. A backplane system according to claim 5, wherein said switch (6) comprises an Ethernet switch.

7. A backplane system according to one of claims 1 to 3, wherein said plurality of components includes a robot control (3b), a remote manager (3c), a drive can (2), and a FC-SCSI interface (3a), and wherein the system further comprises a second backplane support communicatively coupled to said first backplane support (10), said second backplane support including, a second switch (6) located on said second backplane support for concurrently routing multiple units of packetized data between said first backplane support (10) and said second backplane support.

8. A method for routing data between a plurality of electrical components (1, 2, 3, 3a-3e) located within a single assembly (100a, 100b) over a backplane system according to claim 1, the method comprising:
concurrently routing data packets between said electrical component connector (4, 5, 7) and said first switch (6).

9. A method according to claim 8, wherein concurrently routing data packets comprises:
concurrently receiving multiple data packets in said switch (6) located on said first backplane support (10);
interpreting said data packets; and
routing said data packets to said plurality of electrical components (1, 2, 3, 3a-3e) located within said single assembly (100a, 200a).

## Patentansprüche

1. Ein Rückwandplatinensystem zum Leiten von Daten zwischen einer Mehrzahl von elektrischen Komponenten (1, 2, 3, 3a - 3e), die innerhalb einer einzigen Anordnung (100a, 100b) angeordnet sind, wobei das Rückwandplatinensystem folgende Merkmale aufweist:
einen ersten Rückwandplatinenträger (10);
einen ersten Schalter (6), der auf dem ersten Rückwandplatinenträger (10) angeordnet ist und zum gleichzeitigen Leiten von paketierten Daten angepasst ist;
eine Mehrzahl von Elektrische-Komponenten-Verbindern (4, 5, 7), die auf dem Rückwandplatinenträger (10) angeordnet sind, und die jeweils strukturell angepasst sind, um eine elektrische Komponente (1, 2, 3, 3a - 3e) aufzunehmen und zu halten; und
eine Mehrzahl von Signalleitungen (8) zum Leiten paketierter Daten zwischen dem ersten Schalter (6) und zumindest einem Elektrische-Komponenten-Verbinder (4, 5, 7).

2. Ein Rückwandplatinensystem gemäß Anspruch 1, bei dem die Mehrzahl von Elektrische-Komponenten-Verbindern (4, 5, 7) folgende Merkmale aufweist:
einen ersten Elektrische-Komponenten-Verbinder (5), der strukturell angepasst ist, um eine erste elektrische Komponente (2) aufzunehmen und zu halten, zum Übertragen der paketierten Daten zwischen der Anordnung (100a, 200a) und einer externen Vorrichtung (1000, 2000); und
einen zweiten Elektrische-Komponenten-Verbinder (7), der strukturell angepasst ist, um eine zweite elektrische Komponente (3b) aufzunehmen und zu halten, zum Erzeugen und Übertragen paketierter Daten in der Form eines Befehls.

3. Ein Rückwandplatinensystem gemäß Anspruch 2, bei dem die paketierten Daten in der Form eines Befehls gleichzeitig mit den paketierten Daten durch den ersten Schalter (6) geleitet werden, wobei die paketierten Daten in der Form eines Befehls einen paketierten Befehl aufweisen, der verwendet wird, um die erste elektrische Komponente zu steuern.

4. Ein Rückwandplatinensystem gemäß einem der Ansprüche 1 bis 3, bei dem der erste Schalter einen Hub (6) aufweist, wobei der Hub (6) angepasst ist, um die paketierten Daten zu empfangen und die paketierten Daten willkürlich zurück zu der Mehrzahl von elektrischen Komponenten (1, 2, 3, 3a - 3e) zu übertragen, die innerhalb der einzelnen Anordnung (100a, 200a) angeordnet sind.

5. Ein Rückwandplatinensystem gemäß einem der Ansprüche 1 bis 3, bei dem der erste Schalter einen Schalter (6) aufweist, der konfiguriert ist, um paketierte Daten zurück zu einer elektrischen Zielkomponente der Mehrzahl von elektrischen Komponenten (1, 2, 3, 3a - 3e) zu übertragen, zumindest teilweise basierend auf Informationen innerhalb der paketierten Daten.

6. Ein Rückwandplatinensystem gemäß Anspruch 5, bei dem der Schalter (6) einen Ethernet-Schalter aufweist.

7. Ein Rückwandplatinensystem gemäß einem der Ansprüche 1 bis 3, bei dem die Mehrzahl von Komponenten eine automatische Steuerung (3b), eine entfernte Verwaltungseinrichtung (3c), ein Treibergehäuse (2) und eine FC-SCSI-Schnittstelle (3a) umfasst, und wobei das System ferner einen zweiten Rückwandplatinenträger aufweist, der kommunikativ mit dem ersten Rückwandplatinenträger (10) gekoppelt ist, wobei der zweite Rückwandplatinenträger einen zweiten Schalter (6) umfasst, der auf dem zweiten Rückwandplatinenträger angeordnet ist, zum gleichzeitigen Leiten mehrerer Einheiten paketierter Daten zwischen dem ersten Rückwandplatinenträger (10) und dem zweiten Rückwandplatinenträger.

8. Ein Verfahren zum Leiten von Daten zwischen einer Mehrzahl von elektrischen Komponenten (1, 2, 3, 3a - 3e), die innerhalb einer einzelnen Anordnung (100a, 100b) angeordnet sind, über ein Rückwandplatinensystem gemäß Anspruch 1, wobei das Verfahren folgenden Schritt aufweist:
gleichzeitiges Leiten von Datenpaketen zwischen dem Elektrische-Komponenten-Verbinder (4, 5, 7) und dem ersten Schalter (6).

9. Ein Verfahren gemäß Anspruch 8, bei dem das gleichzeitige Leiten von Datenpaketen folgende Schritte aufweist:
gleichzeitiges Empfangen mehrerer Datenpakete in dem Schalter (6), der auf dem ersten Rückwandplatinenträger (10) angeordnet ist;
Interpretieren der Datenpakete; und
Leiten der Datenpakete zu der Mehrzahl von elektrischen Komponenten (1, 2, 3, 3a - 3e), die innerhalb der einzelnen Anordnung (100a, 200a) angeordnet sind.

## Revendications

1. Système de fond de panier pour acheminer des données entre une pluralité de composants électriques (1, 2, 3, 3a-3e) situés à l'intérieur d'un montage unique (100a, 100b), le système de fond de panier comprenant :
un premier support de fond de panier (10) ;
un premier commutateur (6) disposé sur ledit premier support de fond de panier (10) et adapté pour acheminer simultanément des données en paquets ;
une pluralité de connecteurs de composant électrique (4, 5, 7) disposés sur ledit support de fond de panier (10), et chacun étant structurellement adapté pour recevoir et retenir un composant électrique (1, 2, 3, 3a-3e) ; et
une pluralité de circuits d'acheminement de signaux(8) pour acheminer des données en paquets entre ledit premier commutateur (6) et au moins un connecteur de composant électrique (4, 5, 7).

2. Système de fond de panier selon la revendication 1, dans lequel ladite pluralité de connecteurs de composant électrique (4, 5, 7) comprend :
un premier connecteur de composant électrique (5) étant structurellement adapté pour recevoir et retenir un premier composant électrique (2) destiné au transfert desdites données en paquets entre ledit montage (100a, 200a) et un dispositif externe (1000, 2000) ; et
un second connecteur de composant électrique (7) étant structurellement adapté pour recevoir et retenir un second composant électrique (3b) destiné à générer et transférer des données en paquets sous la forme d'une commande.

3. Système de fond de panier selon la revendication 2, dans lequel lesdites données en paquets sous la forme d'une commande sont simultanément acheminées avec lesdites données en paquets par ledit premier commutateur (6), lesdites données en paquets sous la forme d'une commande comprenant une commande en paquets utilisée pour contrôler ledit premier composant électrique.

4. Système de fond de panier selon l'une quelconque des revendications 1 à 3, dans lequel ledit premier commutateur comprend un concentrateur (6), ledit concentrateur (6) étant adapté pour recevoir lesdites données en paquets et pour retransmettre sans discrimination lesdites données en paquets à ladite pluralité de composants électriques (1, 2, 3, 3a-3e) situés à l'intérieur dudit unique montage (100a, 200a).

5. Système de fond de panier selon l'une quelconque des revendications 1 à 3, dans lequel ledit premier commutateur comprend un commutateur (6) configuré pour retransmettre des données en paquets vers un composant électrique cible de ladite pluralité de composants électriques (1, 2, 3, 3a-3e) sur la base, au moins en partie, des informations à l'intérieur desdites données en paquets.

6. Système de fond de panier selon la revendication 5, dans lequel ledit commutateur (6) comprend un commutateur Ethernet.

7. Système de fond de panier selon l'une quelconque des revendications 1 à 3, dans lequel ladite pluralité de composants comprend un contrôle robot (3b), un gestionnaire à distance (3c), un châssis de lecteurs (2) , et une interface FC-SCSI (3a), et dans lequel le système comprend en outre un second support de fond de panier couplé de manière à communiquer avec ledit premier support de fond de panier (10), ledit second support de fond de panier comprenant un second commutateur (6) situé sur ledit second support de fond de panier pour acheminer simultanément de multiples unités de données en paquets entre ledit premier support de fond de panier (10) et ledit second support de fond de panier.

8. Méthode d'acheminement des données entre une pluralité de composants électriques (1, 2, 3, 3a-3e) situés à l'intérieur d'un montage unique (100a, 100b) au moyen d'un système de fond de panier selon la revendication 1, la méthode comprenant :
l'acheminement simultané des paquets de données entre ledit connecteur de composant électrique (4, 5, 7) et ledit premier commutateur (6).

9. Méthode selon la revendication 8, dans laquelle l'acheminement simultané des paquets de données comprend:
la réception simultanée de multiples paquets de données dans ledit commutateur (6) situé sur ledit support de fond de panier (10) ;
l'interprétation desdits paquets de données ; et
l'acheminement desdits paquets de données à ladite pluralité de composants électriques (1, 2, 3, 3a-3e) situés à l'intérieur dudit unique montage (100a, 200a).
